# DEMANDE DE BREVET EUROPEEN

(11) **EP 0 632 488 A1**
(43) Date de publication de la demande: **04.01.1995**
(21) Numéro de dépôt: 94410043.7
(22) Date de dépôt: 27.06.1994
(51) Int. Cl.: H01L 21/321, H01L 21/28

(54) **Procédé de gravure sous plasma d'une couche conductrice sur une tranche de silicium avec interposition d'une couche isolante mince**

(30) Priorité: 30.06.1993 FR 9308217
(71) Demandeur: SGS-THOMSON MICROELECTRONICS S.A., F-94250 Gentilly (FR)
(72) Inventeur: Guillaumot, Bernard, F-38120 Le Fontanil (FR)
(74) Mandataire: de Beaumont, Michel

(57) **Abrégé**

La présente invention concerne un procédé de gravure localisée d'une couche conductrice (4) déposée sur une couche isolante (2), dont au moins des parties sont très minces, ladite couche isolante étant formée sur au moins une face d'une plaquette de silicium (1). Ce procédé comporte l'étape consistant à soumettre la surface en cours de gravure à une irradiation par un rayonnement ultra-violet, au moins pendant la phase finale de la gravure.

## Description

La présente invention concerne un procédé de gravure sous plasma d'une couche conductrice sur une tranche de silicium avec interposition d'une couche isolante mince.

L'article de Sychyi Fang et al. paru dans IEDM, avril 1992, pages 61 à 64, intitulé "A New Model for Thin Oxide Degradation from Wafer Charging in Plasma Etching" analyse des phénomènes destructifs susceptibles de se produire quand on grave sous plasma une couche de silicium polycristallin dopée déposée sur une couche d'oxyde au moins localement très mince, cette couche d'oxyde étant elle-même déposée sur une plaquette de silicium. Cet article expose que, généralement, notamment en présence d'un champ magnétique, un plasma de gravure est non uniforme quant aux charges qui s'accumulent sur la couche de silicium polycristallin soumise à la gravure. Tant que la couche de silicium polycristallin est suffisamment épaisse, et donc suffisamment conductrice, les charges de polarités opposées accumulées sur cette couche se neutralisent mutuellement. Toutefois, vers la phase finale de la gravure, quand la couche de silicium polycristallin devient très mince et peu conductrice ou discontinue, on trouve inévitablement des zones où des charges d'une polarité donnée sont accumulées. Par effet électrostatique, des charges de signe opposé se trouvent donc rassemblées dans le substrat en face des zones d'accumulation de charge et des claquages sont susceptibles de se produire dans des zones de faiblesse de la couche d'oxyde mince comprise entre la couche conductrice et le substrat. Ces claquages sont susceptibles d'être destructifs pour cette couche d'oxyde mince et l'on se trouve donc en présence de zones où la couche d'oxyde est interrompue ce qui rend le dispositif à obtenir non-opérationnel. L'article susmentionné propose un modèle d'analyse du phénomène susmentionné mais ne propose aucune solution pour en supprimer les inconvénients.

L'objet de la présente invention est de prévoir un procédé de gravure sous plasma qui évite les phénomènes de claquage destructif de couches d'oxyde mince formées sous des zones de silicium polycristallin à graver.

Pour atteindre cet objet, la présente invention propose un procédé de gravure sous plasma d'une couche conductrice déposée sur une couche isolante dont au moins une portion est très mince, cette couche isolante étant formée sur au moins une face d'une plaquette de silicium. Au cours de la gravure, et au moins pendant la phase finale de cette gravure, la surface gravée est soumise à un rayonnement ultra-violet. Ce rayonnement ultra-violet est propre à conférer aux porteurs électriques une énergie supérieure à la hauteur de barrière existant entre la couche conductrice à graver et l'oxyde de silicium. Par exemple, dans le cas d'une couche de silicium polycristallin fortement dopée de type N, cette hauteur de barrière est de 3,2 eV et la longueur d'onde du rayonnement ultra-violet devra être inférieure à 280 nm.

La présente invention vise également un réacteur de gravure sous plasma incorporant une ou plusieurs sources de rayonnement ultra-violet irradiant la surface en cours de gravure.

Ces objets, caractéristiques et avantages de la présente invention seront exposés en détail dans la description suivante d'un exemple de mise en oeuvre, faite en relation avec les figures jointes parmi lesquelles :
la figure 1 représente une vue en coupe partielle d'une portion de tranche devant être soumise à une gravure sous plasma ; et
la figure 2 représente une vue en coupe partielle de la même portion de tranche à une phase proche de la fin de la gravure.

Comme cela est classique dans le domaine de la représentation des composants semiconducteurs, les épaisseurs des divers éléments représentés ne sont pas tracées à l'échelle. Classiquement, une tranche de silicium a un diamètre de l'ordre de 10 à 30 cm et une épaisseur de 0,5 à 4 mm. Les couches d'oxyde "mince" ont une épaisseur de l'ordre de 10 à 100 nm, les couches d'oxyde "épais" une épaisseur de l'ordre de 100 à 1000 nm, les couches de silicium polycristallin une épaisseur de l'ordre de 100 à 500 nm, et les couches de résine de masquage une épaisseur supérieure à 1000 nm.

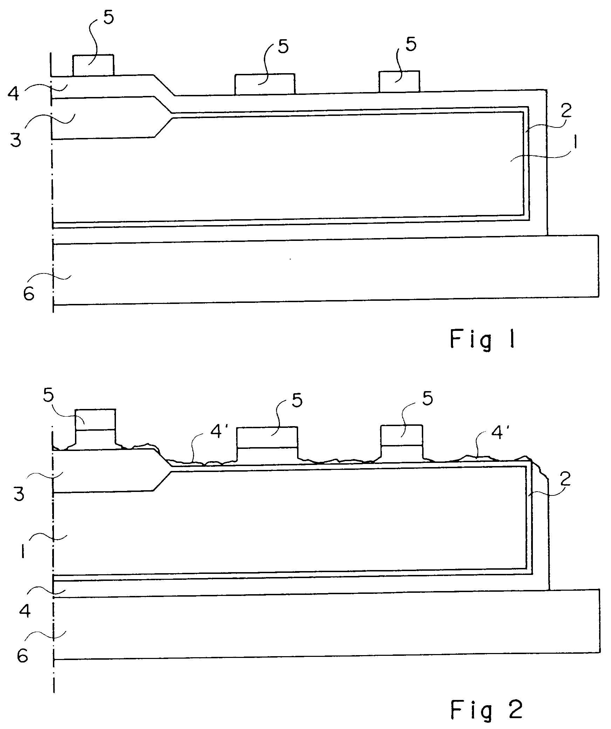

La figure 1 représente à titre d'exemple la partie périphérique d'une tranche de silicium 1 revêtue sur ses deux faces d'une couche d'oxyde mince 2 dont l'épaisseur correspond par exemple à une épaisseur souhaitée d'oxyde de grille d'un transistor MOS (à simple ou double grille). Eventuellement, la tranche a déjà été soumise à des traitements antérieurs et comprend des portions d'oxyde épais 3 et des régions spécifiquement diffusées (non représentées).

Cette tranche est également revêtue sur ses deux faces d'une couche de silicium polycristallin 4 qui doit être gravée spécifiquement, par exemple pour former les grilles de transistors MOS. Pour cela, on a déposé sur la face supérieure de la tranche, au-dessus de la couche de silicium polycristallin 4, un masque 5, constitué par exemple d'une résine photosensible.

Pour opérer la gravure, la tranche est placée sur un support 6 d'un réacteur à plasma, par exemple un réacteur de gravure ionique réactive. Selon le type de processus de gravure utilisé, le support 6 est relié à un potentiel choisi ou à la masse, ou est maintenu électriquement flottant. Ce support peut également être un support chauffé à une température choisie ou un support refroidi.

Le processus de gravure sous plasma permet théoriquement de graver régulièrement la couche 4 perpendiculairement à sa surface.

Néanmoins, comme le représente la figure 2, cette gravure est rarement parfaitement régulière et, vers la fin de la gravure, la couche 4 devient une couche 4' d'épaisseur extrêmement réduite et généralement irrégulière, ce qui provoque les phénomènes décrits dans l'article susmentionné. On trouve donc dans des portions la couche 4', et notamment au voisinage des portions non gravées sous les régions de masquage 5 des accumulations de porteurs de charge de polarité donnée susceptibles de se décharger brutalement à travers des zones de faiblesse de la couche d'oxyde mince 2 et d'introduire des défaillances irrémédiables dans cette couche.

Pour éviter ce phénomène destructif, la présente invention propose d'irradier la surface supérieure de la plaquette en cours de gravure par un rayonnement ultra-violet de longueur d'onde propre à conférer aux porteurs se trouvant sur ou dans la couche conductrice 4 une énergie suffisante pour surmonter la hauteur de barrière de potentiel de la couche isolante 2 et se neutraliser avec les porteurs de signe opposé situés en vis-à-vis dans le substrat de silicium par effet capacitif.

Ainsi, les porteurs transitent régulièrement vers le corps de la plaquette semiconductrice 1, ou de ce corps vers la couche conductrice 4, selon la polarité des charges, et ne peuvent plus s'accumuler dans des portions de la couche conductrice 4' pour provoquer ensuite des claquages brutaux à travers des portions de la couche isolante mince 2.

La longueur d'onde du rayonnement ultra-violet sera choisie pour obtenir l'effet choisi. Par exemple, dans le cas d'une couche de silicium polycristallin fortement dopée de type N sur de l'oxyde de silicium, la hauteur de barrière est de l'ordre de 3,2 eV et les ultra-violets devront avoir une longueur d'onde inférieure à 280 nm.

L'invention s'applique plus généralement à la gravure sous plasma d'une couche conductrice sur une couche isolante mince de même formée sur un substrat conducteur. La longueur d'onde du rayonnement ultra-violet sera adaptée à la nature des couches concernées. L'invention s'applique également à tout autre appareil utilisé en microélectronique susceptible de générer des accumulations de charge au cours du procédé de fabrication, par exemple un implanteur à faisceau d'ions.

La présente invention vise également un appareil pour la mise en oeuvre du procédé selon la présente invention. Cet appareil sera de préférence constitué d'un réacteur de gravure classique à l'intérieur duquel sont disposées une ou plusieurs lampes à ultra-violet produisant une irradiation comprenant au moins une plage de longueur d'onde choisie pour permettre aux porteurs le franchissement de la barrière de potentiel susmentionnée.

## Revendications

1. Procédé de gravure localisée d'une couche conductrice (4) du côté de la face avant d'une structure comprenant une plaquette de silicium (1), une couche isolante (2, 3) recouvrant les deux faces et les côtés de la plaquette et ladite couche conductrice (4) recouvrant les deux faces et les côtés de la couche isolante, au moins une partie (2) de la couche isolante du côté de la face avant étant très mince, caractérisé en ce qu'il comprend les étapes suivantes :
- poser la face arrière de la structure sur un support conducteur (6) d'un réacteur à plasma, et
- soumettre la face avant en cours de gravure à une irradiation par un rayonnement ultraviolet d'énergie suffisante pour permettre à des porteurs de traverser la barrière de potentiel correspondant aux parties très minces de la couche isolante.

2. Procédé selon la revendication 1, caractérisé en ce que ledit support est relié à la masse.

3. Procédé selon la revendication 1, caractérisé en ce que l'irradiation est produite au moins pendant la phase finale de la gravure.

4. Procédé selon la revendication 1, caractérisé en ce que la couche conductrice (4) est une couche de silicium polycristallin dopée pour être conductrice et la couche isolante mince (2) est une couche d'oxyde de silicium.

5. Procédé selon la revendication 4, caractérisé en ce que la longueur d'onde du rayonnement ultra-violet est inférieure à 280 nm.
